(19) Europäisches Patentamt
European Patent Office
Office européen des brevets

(11) EP 3 409 700 B1

(12) **EUROPEAN PATENT SPECIFICATION**

(45) Date of publication and mention of the grant of the patent:
**02.02.2022 Bulletin 2022/05**

(21) Application number: **17744100.3**

(22) Date of filing: **20.01.2017**

(51) International Patent Classification (IPC):
***C08F 212/12*** $^{(2006.01)}$ ***C08F 220/22*** $^{(2006.01)}$
***G03F 7/039*** $^{(2006.01)}$ ***C09D 125/16*** $^{(2006.01)}$

(52) Cooperative Patent Classification (CPC):
(C-Sets available)
**G03F 7/039; C08F 212/12; C08F 212/20; C08F 220/22; C08F 220/24; C09D 125/16; G03F 7/0046; G03F 7/325;** C08F 2800/10 (Cont.)

(86) International application number:
**PCT/JP2017/002023**

(87) International publication number:
**WO 2017/130870 (03.08.2017 Gazette 2017/31)**

(54) **COPOLYMER, POSITIVE RESIST COMPOSITION, AND RESIST PATTERN FORMING METHOD**

COPOLYMER, POSITIVE RESISTZUSAMMENSETZUNG UND VERFAHREN ZUR FORMUNG EINER RESISTSTRUKTUR

COPOLYMÈRE, COMPOSITION DE RÉSINE PHOTOSENSIBLE POSITIVE ET PROCÉDÉ DE FORMATION DE MOTIF DE RÉSINE PHOTOSENSIBLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.01.2016 JP 2016016572**
**29.01.2016 JP 2016016584**

(43) Date of publication of application:
**05.12.2018 Bulletin 2018/49**

(73) Proprietor: **Zeon Corporation**
**Tokyo 100-8246 (JP)**

(72) Inventor: **HOSHINO, Manabu**
**Tokyo 100-8246 (JP)**

(74) Representative: **Maiwald Patent- und Rechtsanwaltsgesellschaft mbH**
**Elisenhof**
**Elisenstraße 3**
**80335 München (DE)**

(56) References cited:
**JP-A- S5 949 536**
**JP-A- H02 115 852**
**JP-A- S57 118 243**
**JP-A- S61 170 735**
**US-A1- 2010 203 450**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 212/12, C08F 220/22;**
**C08F 212/12, C08F 220/24;**
**C08F 212/20, C08F 220/22;**
**C08F 220/22, C08F 212/12;**
**C08F 220/22, C08F 212/20;**
**C08F 220/24, C08F 212/12**

## Description

### TECHNICAL FIELD

This disclosure relates to a polymer, a positive resist composition, and a method of forming a resist pattern and, in particular, to a polymer that can suitably be used as a positive resist, a positive resist composition containing the polymer, and a method of forming a resist pattern using the positive resist composition.

### BACKGROUND

Polymers that display increased solubility in a developer after undergoing main chain scission through irradiation with ionizing radiation, such as an electron beam, or short-wavelength light, such as ultraviolet light, are conventionally used as main chain scission-type positive resists in fields such as semiconductor production. (Hereinafter, the term "ionizing radiation or the like" is used to refer collectively to ionizing radiation and short-wavelength light.)
PTL 1 discloses one example of a main chain scission-type positive resist having high sensitivity. The disclosed positive resist comprises an α-methylstyrene-methyl α-chloroacrylate copolymer that includes an α-methylstyrene unit and a methyl α-chloroacrylate unit.

### CITATION LIST

#### Patent Literature

PTL 1: JP H8-3636 B
JP S57 118243 A relates to a method of forming a fine pattern by irradiating a polymer thin film on a substrate with ionizing radiation.
JP S59 49536 A relates to a method of forming a fine pattern by irradiating a polymer thin film on a substrate with short wavelength radiation.
JP S61 170735 relates to a poly (fluoroalkyl α-chloroacrylate) and a process for producing same for use in a photoresist in a high sensitivity, high resolution positive process.
JP H02 115852 A relates to a method of manufacturing a semiconductor device using a pattern forming process comprising forming a thin film of a radiation positive sensitive polymer and irradiating it.
US 2010/203450 A1 relates to a photoresist composition comprising a polymer capable of radiation induced main chain scission and acid-catalyzed deprotection.

### SUMMARY

#### (Technical Problem)

In a formation process of a resist pattern using a resist, resist pattern collapse may occur during formation of the resist pattern through irradiation with ionizing radiation or the like, development treatment using a developer, and rinse treatment using a rinsing liquid. Therefore, there is demand for the inhibition of resist pattern collapse in formation of a resist pattern using a resist.
However, it has not been possible to sufficiently inhibit resist pattern collapse through the positive resist comprising an α-methylstyrene-methyl α-chloroacrylate copolymer described in PTL 1.
Therefore, an objective of this disclosure is to provide a polymer that can sufficiently inhibit resist pattern collapse when used as a main chain scission-type positive resist.
Another objective of this disclosure is to provide a positive resist composition that can sufficiently inhibit resist pattern collapse.
Yet another objective of this disclosure is to provide a method of forming a resist pattern that can sufficiently inhibit resist pattern collapse and has good patterning efficiency.

#### (Solution to Problem)

The inventor conducted diligent studies with the aim of achieving the objectives described above. Through these studies, the inventor discovered that resist pattern collapse can be sufficiently inhibited when a specific copolymer formed using specific monomers including at least one fluorine atom is used as a main chain scission-type positive resist.
Specifically, this disclosure aims to advantageously solve the problems set forth above by disclosing a polymer comprising: a monomer unit (A) represented by general formula (I), shown below,

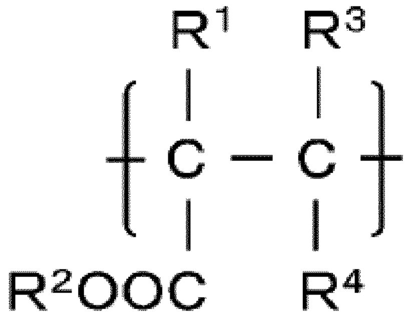 ··· (I)

(in general formula (I), $R^1$ is a chlorine atom, $R^2$ is an unsubstituted alkyl group or a fluorine atom-substituted alkyl group, and $R^3$ and $R^4$ are each a hydrogen atom, a fluorine atom, an unsubstituted alkyl group, or a fluorine atom-substituted alkyl group and may be the same or different), and a monomer unit (B) represented by general formula (II), shown below,

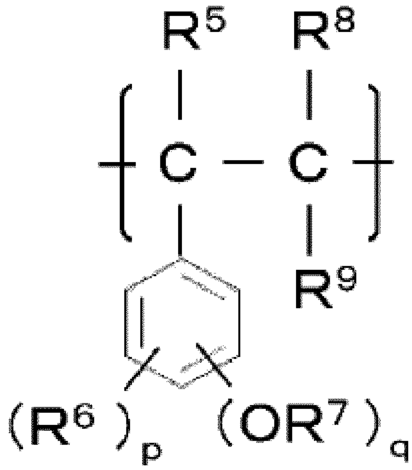 ··· (II)

(in general formula (II), $R^5$, $R^6$, $R^8$, and $R^9$ are each a hydrogen atom, a fluorine atom, an unsubstituted alkyl group, or a fluorine atom-substituted alkyl group and may be the same or different, $R^7$ is a hydrogen atom, an unsubstituted alkyl group, or a fluorine atom-substituted alkyl group, p and q are each an integer of at least 0 and not more than 5, and p + q = 5), wherein at least one of the monomer unit (A) and the monomer unit (B) includes at least one fluorine atom;

the polymer has a weight average molecular weight of at least 10,000 and not more than 150,000; and
the polymer has a molecular weight distribution (Mw/Mn) of at least 1.30 and not more than 1.60.

The polymer including the specific monomer units (A) and (B), at least one of which includes at least one fluorine atom, can sufficiently inhibit resist pattern collapse when used as a resist and can favorably be used as a main chain scission-type positive resist.

Note that in a case in which p in formula (II) is 2 or more, the plurality of $R^6$ groups may be the same or different. Likewise, in a case in which q in formula (II) is 2 or more, the plurality of $R^7$ groups may be the same or different.

In the presently disclosed polymer, $R^1$ is a chlorine atom. When $R^1$ of the monomer unit (A) is a chlorine atom, main chain scission properties upon irradiation with ionizing radiation or the like can be improved. Accordingly, the polymer can be particularly favorably used as a main chain scission-type positive resist. Moreover, it is easy to produce a polymer for which $R^1$ of the monomer unit (A) is a chlorine atom.

Also, in the presently disclosed polymer, it is preferable that $R^2$ is a fluorine atom-substituted alkyl group, and $R^3$ and $R^4$ are each a hydrogen atom or an unsubstituted alkyl group. When $R^2$ of the monomer unit (A) is a fluorine atom-substituted alkyl group, and $R^3$ and $R^4$ of the monomer unit (A) are each a hydrogen atom or an unsubstituted alkyl group, main chain scission properties upon irradiation with ionizing radiation or the like can be improved. Accordingly, the polymer can be particularly favorably used as a main chain scission-type positive resist.

Moreover, in the presently disclosed polymer, it is preferable that $R^5$ to $R^9$ are each a hydrogen atom or an unsubstituted alkyl group, and the monomer unit (A) includes at least one fluorine atom. A polymer for which $R^5$ to $R^9$ of the monomer unit (B) are each a hydrogen atom or an unsubstituted alkyl group, and for which the monomer unit (A) includes at least one fluorine atom is easy to produce and has excellent main chain scission properties upon irradiation

with ionizing radiation or the like.

The polymer has a weight average molecular weight of not more than 150,000. Furthermore, it is preferable that the presently disclosed polymer has a weight average molecular weight of less than 22,000. The polymer having a weight average molecular weight of less than 22,000 can sufficiently inhibit resist pattern collapse when used as a positive resist while also having sensitivity that is raised to an appropriate level, which enables favorable use of the polymer as a main chain scission-type positive resist.

Herein, "weight average molecular weight (Mw)" can be measured by gel permeation chromatography.

Moreover, the presently disclosed polymer has a weight average molecular weight of 10,000 or more. When the weight average molecular weight of the polymer is 10,000 or more, excessive $\gamma$ value reduction can be inhibited in a case in which the polymer is used in a main chain scission-type positive resist composition.

Also, the presently disclosed polymer has a molecular weight distribution (Mw/Mn) of at least 1.30 and not more than 1.60. When the molecular weight distribution of the polymer is within the range set forth above, it is possible to increase ease of production of the polymer and clarity of a resist pattern.

Herein, "molecular weight distribution (Mw/Mn)" refers to the ratio of weight average molecular weight (Mw) to number average molecular weight (Mn). Moreover, "number average molecular weight (Mn)" can be measured by gel permeation chromatography in the same manner as "weight average molecular weight (Mw)" described above.

Furthermore, this disclosure aims to advantageously solve the problems set forth above by disclosing a positive resist composition comprising: any one of the polymers set forth above; and a solvent. When a positive resist composition contains the polymer set forth above as a positive resist, the positive resist composition can sufficiently inhibit resist pattern collapse when used in formation of a resist pattern and can favorably form a resist pattern.

Also, this disclosure aims to advantageously solve the problems set forth above by disclosing a method of forming a resist pattern comprising: forming a resist film using the positive resist composition set forth above; exposing the resist film; and developing the resist film that has been exposed, wherein the developing is carried out using a developer that contains an alcohol and a fluorine-containing solvent and has a fluorine-containing solvent content of 60 vol% or more. When a resist film formed using the positive resist composition set forth above is developed using a developer that contains an alcohol and a fluorine-containing solvent and has a fluorine-containing solvent content of 60 vol% or more, a clear resist pattern can be efficiently formed.

(Advantageous Effect)

Through the presently disclosed polymer, it is possible to provide a main chain scission-type positive resist that can sufficiently inhibit resist pattern collapse when the polymer is used as a resist.

Moreover, the presently disclosed positive resist composition enables favorable formation of a resist pattern.

Furthermore, the presently disclosed method of forming a resist pattern can sufficiently inhibit resist pattern collapse while also enabling efficient formation of a resist pattern.

DETAILED DESCRIPTION

The following provides a detailed description of embodiments of this disclosure.

The presently disclosed polymer can be favorably used as a main chain scission-type positive resist that undergoes main chain scission to lower molecular weight upon irradiation with ionizing radiation, such as an electron beam or EUV laser, or short-wavelength light, such as ultraviolet light. The presently disclosed positive resist composition contains the presently disclosed polymer as a positive resist and can be used, for example, in formation of a resist pattern in a production process of a printed board such as a build-up board.

(Polymer)

The presently disclosed polymer includes: a monomer unit (A) represented by general formula (I), shown below,

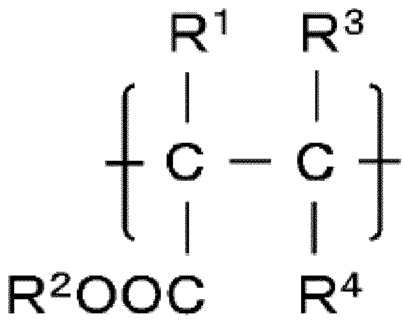

··· (I)

(in formula (I), $R^1$ is a chlorine atom, $R^2$ is an unsubstituted alkyl group or a fluorine atom-substituted alkyl group, and $R^3$ and $R^4$ are each a hydrogen atom, a fluorine atom, an unsubstituted alkyl group, or a fluorine atom-substituted alkyl group and may be the same or different); and

a monomer unit (B) represented by general formula (II), shown below,

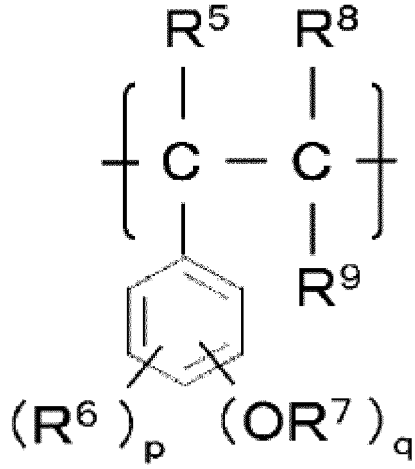

··· (II)

(in formula (II), $R^5$, $R^6$, $R^8$, and $R^9$ are each a hydrogen atom, a fluorine atom, an unsubstituted alkyl group, or a fluorine atom-substituted alkyl group and may be the same or different, $R^7$ is a hydrogen atom, an unsubstituted alkyl group, or a fluorine atom-substituted alkyl group, p and q are each an integer of at least 0 and not more than 5, and p + q = 5). Moreover, in the presently disclosed polymer, at least one of the monomer unit (A) and the monomer unit (B) includes at least one fluorine atom. In other words, the presently disclosed polymer may be a polymer in which the monomer unit (A) includes at least one fluorine atom and the monomer unit (B) does not include a fluorine atom, a polymer in which the monomer unit (B) includes at least one fluorine atom and the monomer unit (A) does not include a fluorine atom, or a polymer in which the monomer unit (A) and the monomer unit (B) each include at least one fluorine atom.

Although the presently disclosed polymer may further include any monomer unit other than the monomer unit (A) and the monomer unit (B), the proportion constituted by the monomer unit (A) and the monomer unit (B), in total, among all monomer units included in the polymer is preferably 90 mol% or more, more preferably substantially 100 mol%, and even more preferably 100 mol% (i.e., the polymer preferably only includes the monomer unit (A) and the monomer unit (B)).

Through inclusion of the specific monomer units (A) and (B), the presently disclosed polymer can undergo main chain scission to lower molecular weight upon irradiation with ionizing radiation or the like (for example, an electron beam, KrF laser, ArF laser, or extreme ultraviolet (EUV) laser). Moreover, as a result of at least one of the monomer unit (A) and the monomer unit (B) in the presently disclosed polymer including at least one fluorine atom, resist pattern collapse can be sufficiently inhibited when the presently disclosed polymer is used as a resist.

Although the reason that resist pattern collapse can be inhibited through inclusion of a fluorine atom in at least one of the monomer unit (A) and the monomer unit (B) is not clear, it is presumed that as a result of liquid repellency of the polymer being enhanced, it is possible to inhibit pulling that arises between pattern sections during removal of a developer or rinsing liquid in the resist pattern formation process.

<Monomer unit (A)>

The monomer unit (A) is a structural unit that is derived from a monomer (a) represented by general formula (III), shown below.

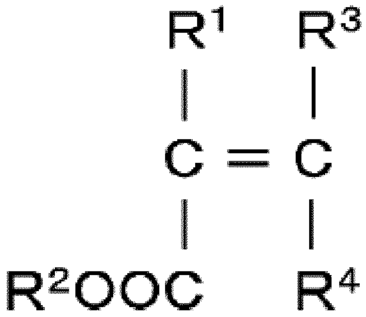

··· (III)

(In formula (III), $R^1$ to $R^4$ are the same as in formula (I).)

The proportion constituted by the monomer unit (A) among all monomer units included in the polymer is not specifically limited but may, for example, be set as at least 30 mol% and not more than 70 mol%.

Examples of fluorine atom-substituted alkyl groups that may form any of $R^2$ to $R^4$ in formulae (I) and (III) include, but are not specifically limited to, groups having a structure in which all or some of the hydrogen atoms of an alkyl group are substituted with fluorine atoms.

Examples of unsubstituted alkyl groups that may form any of $R^2$ to $R^4$ in formulae (I) and (III) include, but are not specifically limited to, unsubstituted alkyl groups having a carbon number of at least 1 and not more than 10. Of such alkyl groups, a methyl group or an ethyl group is preferable as an unsubstituted alkyl group that may form any of $R^2$ to $R^4$.

From a viewpoint of improving main chain scission properties of the polymer upon irradiation with ionizing radiation or the like, $R^1$ in formulae (I) and (III) is a chlorine atom. Note that $R^1$ being a chlorine atom is also advantageous in terms that a monomer (a) for which $R^1$ in formula (III) is a chlorine atom has excellent polymerizability, and a polymer including a monomer unit (A) for which $R^1$ in formula (I) is a chlorine atom is easy to produce.

Moreover, from a viewpoint of improving main chain scission properties of the polymer upon irradiation with ionizing radiation or the like, $R^2$ in formulae (I) and (III) is preferably a fluorine atom-substituted alkyl group, more preferably a fluorine atom-substituted alkyl group having a carbon number of at least 1 and not more than 10, even more preferably a 2,2,2-trifluoroethyl group, a 2,2,3,3,3-pentafluoropropyl group, a 2-(perfluorobutyl)ethyl group, a 2-(perfluorohexyl)ethyl group, a 1H, 1H, 3H-tetrafluoropropyl group, a 1H, 1H, 5H-octafluoropentyl group, a 1H, 1H, 7H-dodecafluoroheptyl group, a 1H-1-(trifluoromethyl)trifluoroethyl group, a 1H,1H,3H-hexafluorobutyl group, or a 1,2,2,2-tetrafluoro-1-(trifluoromethyl)ethyl group, and is particularly preferably a 2,2,2-trifluoroethyl group.

Furthermore, from a viewpoint of improving main chain scission properties of the polymer upon irradiation with ionizing radiation or the like, $R^3$ and $R^4$ in formulae (I) and (III) are each preferably a hydrogen atom or an unsubstituted alkyl group, more preferably a hydrogen atom or an unsubstituted alkyl group having a carbon number of at least 1 and not more than 5, and even more preferably a hydrogen atom.

Examples of the monomer (a) represented by formula (III) described above that can form the monomer unit (A) represented by formula (I) described above include, but are not specifically limited to, fluoroalkyl esters of $\alpha$-chloroacrylic acid such as 2,2,2-trifluoroethyl $\alpha$-chloroacrylate, 2,2,3,3,3-pentafluoropropyl $\alpha$-chloroacrylate, 2-(perfluorobutyl)ethyl $\alpha$-chloroacrylate, 2-(perfluorohexyl)ethyl a-chloroacrylate, 1H,1H,3H-tetrafluoropropyl a-chloroacrylate, 1H,1H,5H-octafluoropentyl a-chloroacrylate, 1H,1H,7H-dodecafluoroheptyl a-chloroacrylate, 1H-1-(trifluoromethyl)trifluoroethyl $\alpha$-chloroacrylate, 1H,1H,3H-hexafluorobutyl a-chloroacrylate, and 1,2,2,2-tetrafluoro-1-(trifluoromethyl) ethyl $\alpha$-chloroacrylate.

From a viewpoint of further improving main chain scission properties of the polymer upon irradiation with ionizing radiation or the like, the monomer unit (A) is preferably a structural unit that is derived from a fluoroalkyl ester of $\alpha$-chloroacrylic acid. In other words, it is particularly preferable that in formulae (I) and (III), $R^1$ is a chlorine atom, $R^2$ is a fluorine atom-substituted alkyl group, and $R^3$ and $R^4$ are each a hydrogen atom.

<Monomer unit (B)>

The monomer unit (B) is a structural unit that is derived from a monomer (b) represented by general formula (IV), shown below.

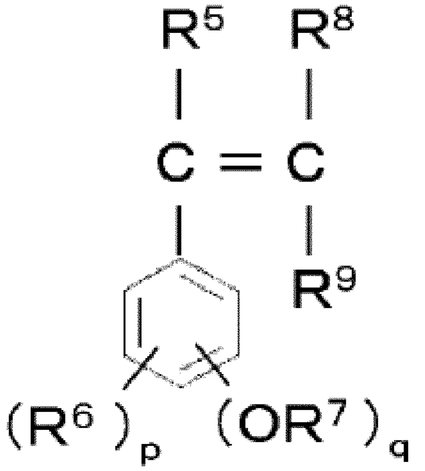

... (IV)

(In formula (IV), $R^5$ to $R^9$, p, and q are the same as in formula (II).)

The proportion constituted by the monomer unit (B) among all monomer units included in the polymer is not specifically limited but may, for example, be set as at least 30 mol% and not more than 70 mol%.

Examples of fluorine atom-substituted alkyl groups that may form any of $R^5$ to $R^9$ in formulae (II) and (IV) include, but are not specifically limited to, groups having a structure in which all or some of the hydrogen atoms of an alkyl group are substituted with fluorine atoms.

Examples of unsubstituted alkyl groups that may form any of $R^5$ to $R^9$ in formulae (II) and (IV) include, but are not specifically limited to, unsubstituted alkyl groups having a carbon number of at least 1 and not more than 5. Of such alkyl groups, a methyl group or an ethyl group is preferable as an unsubstituted alkyl group that may form any of $R^5$ to $R^9$.

From a viewpoint of improving ease of production of the polymer and main chain scission properties of the polymer upon irradiation with ionizing radiation or the like, $R^5$ in formulae (II) and (IV) is preferably a hydrogen atom or an unsubstituted alkyl group, more preferably an unsubstituted alkyl group having a carbon number of at least 1 and not more than 5, and even more preferably a methyl group.

Moreover, from a viewpoint of improving ease of production of the polymer and main chain scission properties of the polymer upon irradiation with ionizing radiation or the like, the plurality of $R^6$ and/or $R^7$ groups that are present in formulae (II) and (IV) are each preferably a hydrogen atom or an unsubstituted alkyl group, more preferably a hydrogen atom or an unsubstituted alkyl group having a carbon number of at least 1 and not more than 5, and even more preferably a hydrogen atom.

Note that in formulae (II) and (IV), from a viewpoint of improving ease of production of the polymer and main chain scission properties of the polymer upon irradiation with ionizing radiation or the like, it is preferable that p is 5, q is 0, and the five $R^6$ groups are each a hydrogen atom or an unsubstituted alkyl group, more preferable that the five $R^6$ groups are each a hydrogen atom or an unsubstituted alkyl group having a carbon number of at least 1 and not more than 5, and even more preferable that the five $R^6$ groups are each a hydrogen atom.

On the other hand, from a viewpoint of further inhibiting resist pattern collapse when the polymer is used in formation of a resist pattern, the plurality of $R^6$ and/or $R^7$ groups that are present in formulae (II) and (IV) preferably include a fluorine atom or a fluorine atom-substituted alkyl group, and more preferably include a fluorine atom or a fluorine atom-substituted alkyl group having a carbon number of at least 1 and not more than 5.

Furthermore, from a viewpoint of improving ease of production of the polymer and main chain scission properties of the polymer upon irradiation with ionizing radiation or the like, $R^8$ and $R^9$ in formulae (II) and (IV) are each preferably a hydrogen atom or an unsubstituted alkyl group, more preferably a hydrogen atom or an unsubstituted alkyl group having a carbon number of at least 1 and not more than 5, and even more preferably a hydrogen atom.

Examples of the monomer (b) represented by formula (IV) described above that may be used to form the monomer unit (B) represented by formula (II) described above include, but are not specifically limited to, $\alpha$-methylstyrene and derivatives thereof such as (b-1) to (b-11), shown below.

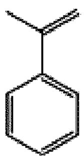
(b-1)

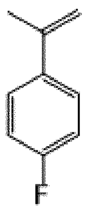
(b-2)

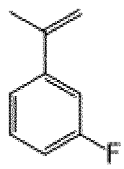
(b-3)

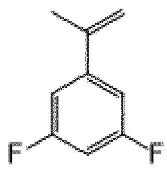
(b-4)

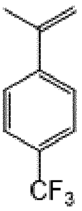
(b-5)

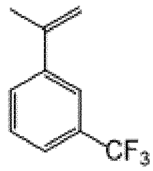
(b-6)

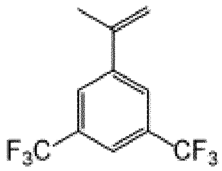
(b-7)

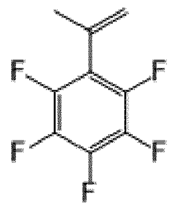
(b-8)

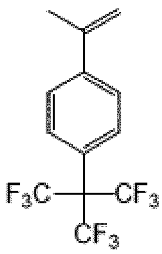
(b-9)

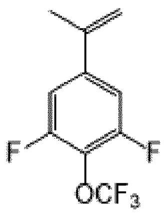
(b-10)

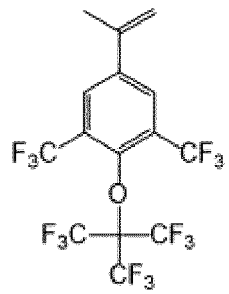
(b-11)

Note that from a viewpoint of improving ease of production of the polymer and main chain scission properties of the polymer upon irradiation with ionizing radiation or the like, the monomer unit (B) preferably does not include a fluorine atom (i.e., preferably only the monomer unit (A) includes a fluorine atom), and is more preferably a structural unit derived from $\alpha$-methylstyrene. In other words, it is particularly preferable that in formulae (II) and (IV), p = 5, q = 0, $R^5$ is a methyl group, all five $R^6$ groups are hydrogen atoms, and $R^8$ and $R^9$ are each a hydrogen atom.

<Properties of polymer>

[Weight average molecular weight]

The weight average molecular weight (Mw) of the presently disclosed polymer including the monomer unit (A) and the monomer unit (B) described above is at least 10,000 and not more than 150,000. Moreover, the weight average molecular weight (Mw) of the presently disclosed polymer is preferably less than 22,000, and more preferably less than 21,900, and is preferably 15,000 or more. When the weight average molecular weight (Mw) of the polymer is not more than (less than) any of the upper limits set forth above, solubility of the polymer in a developer can be increased through a comparatively low irradiation dose when the polymer is used as a positive resist, and consequently sensitivity can be improved to an appropriate level when the polymer is used as a positive resist. Moreover, when the weight average molecular weight (Mw) of the polymer is at least any of the lower limits set forth above, it is possible to inhibit increased resist film solubility in a developer through an excessively low irradiation dose and inhibit excessive $\gamma$ value reduction.

[Number average molecular weight]

The number average molecular weight (Mn) of the presently disclosed polymer may, for example, be set as at least 10,000 and not more than 100,000. Moreover, the number average molecular weight (Mn) of the presently disclosed polymer is preferably less than 22,000, and more preferably less than 15,000. When the number average molecular weight (Mn) of the polymer is not more than (less than) any of the upper limits set forth above, sensitivity can be further increased when a resist formed using a positive resist composition that contains the polymer is used as a positive resist.

[Molecular weight distribution]

The molecular weight distribution (Mw/Mn) of the presently disclosed polymer is 1.30 or more, and preferably 1.35 or more, and not more than 1.60, and preferably 1.55 or less. When the molecular weight distribution (Mw/Mn) of the polymer is at least any of the lower limits set forth above, the polymer is easier to produce. Moreover, when the molecular weight distribution (Mw/Mn) of the polymer is not more than any of the upper limits set forth above, it is possible to increase the γ value when the polymer is used as a positive resist and increase the clarity of an obtained resist pattern.

[Proportion of components having molecular weight of less than 6,000]

The proportion of components in the presently disclosed polymer having a molecular weight of less than 6,000 is preferably more than 2%, and more preferably more than 6%, and is preferably 10% or less. When the proportion of components having a molecular weight of less than 6,000 is more than 2%, it is possible to further increase sensitivity when the polymer is used as a positive resist. Moreover, when the proportion of components having a molecular weight of less than 6,000 is 10% or less, it is possible to inhibit excessive γ value reduction when the polymer is used as a positive resist.

[Proportion of components having molecular weight of less than 10,000]

The proportion of components in the presently disclosed polymer having a molecular weight of less than 10,000 is preferably 5% or more, more preferably 10% or more, and even more preferably 15% or more, and is preferably 30% or less, and more preferably 25% or less. When the proportion of components having a molecular weight of less than 10,000 is 5% or more, it is possible to further increase sensitivity when the polymer is used as a positive resist. Moreover, when the proportion of components having a molecular weight of less than 10,000 is 30% or less, it is possible to inhibit excessive γ value reduction when the polymer is used as a positive resist.

[Proportion of components having molecular weight of more than 50,000]

The proportion of components in the presently disclosed polymer having a molecular weight of more than 50,000 is preferably 7% or less, and more preferably 5% or less. When the proportion of components having a molecular weight of more than 50,000 is 7% or less, it is possible to further increase sensitivity when the polymer is used as a positive resist.

[Proportion of components having molecular weight of more than 80,000]

The proportion of components in the presently disclosed polymer having a molecular weight of more than 80,000 is preferably 1% or less, and more preferably 0.9% or less. When the proportion of components having a molecular weight of more than 80,000 is 1% or less, it is possible to further increase sensitivity when the polymer is used as a positive resist.

(Production method of polymer)

The polymer including the monomer unit (A) and the monomer unit (B) set forth above can be produced, for example, by carrying out polymerization of a monomer composition that contains the monomer (a) and the monomer (b), and then optionally purifying the obtained polymerized product.

The composition, molecular weight distribution, weight average molecular weight, and number average molecular weight of the polymer can be adjusted by altering the polymerization conditions and the purification conditions. In one specific example, the composition of the polymer can be adjusted by altering the percentage content of each monomer in the monomer composition used in polymerization. In another example, the weight average molecular weight and the number average molecular weight can be reduced by raising the polymerization temperature. In yet another example, the weight average molecular weight and the number average molecular weight can be reduced by shortening the polymerization time.

<Polymerization of monomer composition>

The monomer composition used in production of the presently disclosed polymer may be a mixture containing a monomer component that includes the monomer (a) and the monomer (b), an optional solvent, a polymerization initiator, and optionally added additives. Polymerization of the monomer composition may be carried out by a known

method. In particular, the use of cyclopentanone or the like as the solvent is preferable, and the use of a radical polymerization initiator such as azobisisobutyronitrile as the polymerization initiator is preferable.

A polymerized product obtained through polymerization of the monomer composition may, without any specific limitations, be collected by adding a good solvent such as tetrahydrofuran to a solution containing the polymerized product and subsequently dripping the solution to which the good solvent has been added into a poor solvent such as methanol to coagulate the polymerized product.

<Purification of polymerized product>

The method of purification in a case in which the obtained polymerized product is purified may be, but is not specifically limited to, a known purification method such as re-precipitation or column chromatography. Of these purification methods, purification by re-precipitation is preferable.

Note that purification of the polymerized product may be performed repeatedly.

Purification of the polymerized product by re-precipitation is, for example, preferably carried out by dissolving the resultant polymerized product in a good solvent such as tetrahydrofuran, and subsequently dripping the resultant solution into a mixed solvent of a good solvent, such as tetrahydrofuran, and a poor solvent, such as methanol, to precipitate a portion of the polymerized product. When purification of the polymerized product is carried out by dripping a solution of the polymerized product into a mixed solvent of a good solvent and a poor solvent as described above, the molecular weight distribution, weight average molecular weight, and number average molecular weight of the resultant polymer can easily be adjusted by altering the types and/or mixing ratio of the good solvent and the poor solvent. In one specific example, the molecular weight of polymer that precipitates in the mixed solvent can be increased by increasing the proportion of the good solvent in the mixed solvent.

Also note that in a situation in which the polymerized product is purified by re-precipitation, polymerized product that precipitates in the mixed solvent of the good solvent and the poor solvent may be used as the presently disclosed polymer, or polymerized product that does not precipitate in the mixed solvent (i.e., polymerized product dissolved in the mixed solvent) may be used as the presently disclosed polymer. Polymerized product that does not precipitate in the mixed solvent can be collected from the mixed solvent by a known technique such as concentration to dryness.

(Positive resist composition)

The presently disclosed positive resist composition contains the polymer set forth above and a solvent, and may optionally further contain known additives that can be included in resist compositions. As a result of the presently disclosed positive resist composition containing the polymer set forth above as a positive resist, the presently disclosed positive resist composition can sufficiently inhibit resist pattern collapse when used in formation of a resist pattern.

<Solvent>

The solvent may be any known solvent in which the above-described polymer is soluble. Of such solvents, anisole is preferable from a viewpoint of obtaining a positive resist composition of appropriate viscosity and improving coatability of the positive resist composition.

(Method of forming resist pattern)

The presently disclosed method of forming a resist pattern preferably uses the presently disclosed positive resist composition set forth above. Specifically, the presently disclosed method of forming a resist pattern preferably includes (1) a step of forming a resist film using the presently disclosed positive resist composition, (2) a step of exposing the resist film, and (3) a step of developing the resist film that has been exposed. Moreover, in the presently disclosed method of forming a resist pattern, the developing of step (3) is preferably carried out using a developer that contains an alcohol and a fluorine-containing solvent and has a fluorine-containing solvent content of 60 vol% or more. When a resist film comprising the presently disclosed fluorine atom-containing polymer is developed using a specific developer having a fluorine-containing solvent content of 60 vol% or more, it is possible to efficiently and favorably form a clear resist pattern.

<Resist film formation step>

In step (1), the presently disclosed positive resist composition is applied onto a workpiece, such as a substrate, that is to be processed using a resist pattern, and the applied positive resist composition is dried to form a resist film. No specific limitations are placed on the application method and the drying method, and known application methods

and drying methods may be adopted.

<Exposure step>

In step (2), the resist film is irradiated with ionizing radiation or light to write a desired pattern. Irradiation with ionizing radiation or light can be carried out using a known writing device such as an electron beam writer or a laser writer.

<Development step>

In step (3), the resist film in which a pattern has been written is brought into contact with a developer to develop the resist film and form a resist pattern on the workpiece. The method by which the resist film and the developer are brought into contact may be, but is not specifically limited to, a method using a known technique such as immersion of the resist film in the developer or application of the developer onto the resist film. The developed resist film is rinsed with a rinsing liquid.

In particular, examples of developers and rinsing liquids that may be used include fluorine-containing solvents such as fluorocarbons including $CF_3CFHCFHCF_2CF_3$, $CF_3CF_2CHCl_2$, $CClF_2CF_2CHClF$, $CF_3CF_2CF_2CF_2OCH_3$, and $C_8F_{18}$; alcohols such as methanol, ethanol, 1-propanol, and 2-propanol (isopropyl alcohol); alkyl group-containing acetic acid esters such as amyl acetate and hexyl acetate; mixtures of a fluorine-containing solvent and an alcohol; mixtures of a fluorine-containing solvent and an alkyl group-containing acetic acid ester; mixtures of an alcohol and an alkyl group-containing acetic acid ester; and mixtures of a fluorine-containing solvent, an alcohol, and an alkyl group-containing acetic acid ester. The combination of developer and rinsing liquid may, for example, be set such that a solvent in which resist solubility is higher is used as a developer and a solvent in which resist solubility is lower is used as a rinsing liquid in consideration of solubility of a resist comprising the polymer set forth above, for example. In selection of the developer, it is preferable to select a developer that does not cause dissolution of the resist film prior to implementation of step (2). Moreover, in selection of the rinsing liquid, it is preferable to select a rinsing liquid that readily mixes with the developer such that the developer is readily replaced by the rinsing liquid.

In particular, it is preferable that the developer used in the presently disclosed method of forming a resist pattern is 90 vol% or more alcohol and fluorine-containing solvent. The developer is more preferably 95 vol% or more alcohol and fluorine-containing solvent, and most preferably 100 mass% alcohol and fluorine-containing solvent. Moreover, the developer is preferably 60 vol% or more fluorine-containing solvent, and more preferably 70 vol% or more fluorine-containing solvent. When a resist film comprising the presently disclosed polymer is developed using a developer that contains an alcohol and a fluorine-containing solvent and is 60 vol% or more fluorine-containing solvent, it is possible to increase the $\gamma$ value and increase the clarity of an obtained resist pattern.

EXAMPLES

The following provides a more specific description of this disclosure based on examples. However, this disclosure is not limited to the following examples. In the following description, "%" and "parts" used in expressing quantities are by mass, unless otherwise specified.

The following methods were used to measure and evaluate the weight average molecular weight, number average molecular weight, and molecular weight distribution of a polymer, and $E_{th}$ (sensitivity) and pattern collapse resistance of a positive resist comprising the polymer in Examples 1 to 4 and Comparative Example 1, and additionally the proportions of components in the polymer having various molecular weights and the $\gamma$ value of the positive resist comprising the polymer in Examples 5 to 8. The polymers of Examples 1 to 4, 7 and 8 are not according to claim 1 and are therefore reference examples.

<Weight average molecular weight, number average molecular weight, and molecular weight distribution>

The weight average molecular weight (Mw) and number average molecular weight (Mn) of an obtained polymer were measured by gel permeation chromatography, and then the molecular weight distribution (Mw/Mn) of the polymer was calculated.

Specifically, the weight average molecular weight (Mw) and number average molecular weight (Mn) of the polymer were determined as values in terms of standard polystyrene using a gel permeation chromatograph (HLC-8220 produced by Tosoh Corporation) with tetrahydrofuran as a developing solvent. The molecular weight distribution (Mw/Mn) was then calculated.

<Sensitivity ($E_{th}$) of resist film>

A spin coater (MS-A150 produced by Mikasa Co., Ltd.) was used to apply a positive resist composition onto a silicon wafer of 4 inches in diameter such as to have a thickness of 500 nm. The applied positive resist composition was heated for 3 minutes by a hot-plate at a temperature of 180°C to form a resist film on the silicon wafer. An electron beam writing device (ELS-S50 produced by Elionix Inc.) was used to write a plurality of patterns (dimensions: 500 $\mu$m × 500 $\mu$m) over the resist film with different electron beam irradiation doses, development treatment was carried out for 1 minute at a temperature of 23°C using isopropyl alcohol (Examples 1 to 4 and Comparative Example 1) or a developer obtained by mixing a fluorine-containing solvent (produced by Du Pont-Mitsui Fluorochemicals Co., Ltd.; Vertrel® XF (Vertrel XF is a registered trademark in Japan, other countries, or both); $CF_3CFHCFHCF_2CF_3$) and isopropyl alcohol in a specific volume ratio (Examples 5 to 8) as a resist developer, and then rinsing was carried out for 10 seconds using a fluorine-containing solvent (produced by Du Pont-Mitsui Fluorochemicals Co., Ltd.; Vertrel ($CF_3CFHCFHCF_2CF_3$)) as a rinsing liquid. The electron beam irradiation dose was varied in a range of 4 $\mu C/cm^2$ to 200 $\mu C/cm^2$ in increments of 4 $\mu C/cm^2$. Next, an optical film thickness meter (Lambda Ace produced by Dainippon Screen Mfg. Co., Ltd.) was used to measure the thickness of the resist film in regions in which writing had been performed. A sensitivity curve was prepared that indicated a relationship between the common logarithm of the total electron beam irradiation dose and the remaining film fraction of the resist film after development (= thickness of resist film after development/thickness of resist film formed on silicon wafer).

The obtained sensitivity curve (horizontal axis: common logarithm of total electron beam irradiation dose; vertical axis: remaining film fraction of resist film ($0 \leq$ remaining film fraction $\leq 1.00$)) was fitted to a quadratic function in a range from a remaining film fraction of 0.20 to a remaining film fraction of 0.80, and a straight line that joined points on the obtained quadratic function (function of remaining film fraction and common logarithm of total irradiation dose) corresponding to remaining film fractions of 0 and 0.50 (linear approximation for gradient of sensitivity curve) was prepared. The total electron beam irradiation dose $E_{th}$ ($\mu C/cm^2$) was determined for when the remaining film fraction on the obtained straight line (function of remaining film fraction and common logarithm of total irradiation dose) was 0. In Examples 1 to 4 and Comparative Example 1, the sensitivity was evaluated in accordance with the following standard. A smaller value for $E_{th}$ indicates higher sensitivity and that the polymer used as the positive resist more readily undergoes scission at a low irradiation dose.

A: $E_{th}$ of 200 $\mu C/cm^2$ or less
B: $E_{th}$ of more than 200 $\mu C/cm^2$ and not more than 600 $\mu C/cm^2$
C: $E_{th}$ of more than 600 $\mu C/cm^2$

<Pattern collapse resistance>

A spin coater (MS-A150 produced by Mikasa Co., Ltd.) was used to apply a positive resist composition onto a silicon wafer of 4 inches in diameter. Next, the applied positive resist composition was heated for 3 minutes by a hot-plate at a temperature of 180°C to form a resist film of 40 nm in thickness on the silicon wafer. An electron beam writing device (ELS-S50 produced by Elionix Inc.) was used to write a pattern through exposure of the resist film to an optimal exposure dose ($E_{op}$). Development treatment was subsequently carried out for 1 minute at a temperature of 23°C using isopropyl alcohol (Examples 1 to 4 and Comparative Example 1) or a developer obtained by mixing a fluorine-containing solvent (produced by Du Pont-Mitsui Fluorochemicals Co., Ltd.; Vertrel® XF; $CF_3CFHCFHCF_2CF_3$) and isopropyl alcohol in a specific volume ratio (Examples 5 to 8) as a resist developer, and then rinsing was carried out for 10 seconds using a fluorine-containing solvent (produced by Du Pont-Mitsui Fluorochemicals Co., Ltd.; Vertrel ($CF_3CFHCFHCF_2CF_3$)) as a rinsing liquid to form a resist pattern. The occurrence of pattern collapse of the formed resist pattern was inspected. Note that the optimal exposure dose ($E_{op}$) was set as appropriate with a value approximately double $E_{th}$ as a rough guide. Lines (non-exposed regions) and spaces (exposed regions) of the resist pattern were each set as 20 nm.

Pattern collapse resistance was evaluated in accordance with the following standard.

A: Pattern collapse not observed
B: Pattern collapse observed

<Proportions of components in polymer having various molecular weights>

A chromatogram of each polymer obtained in Examples 5 to 8 was obtained using a gel permeation chromatograph (HLC-8220 produced by Tosoh Corporation) with tetrahydrofuran as a developing solvent. The total area (A) of all peaks and the total area (X) of peaks for components having a molecular weight within a specific range were determined from the obtained chromatogram. Specifically, the proportions of components having molecular weights within specific

ranges defined by the following threshold values were calculated.

$$\text{Proportion (\%) of components } (X_6) \text{ having molecular weight of less than 6,000} = (X_6/A) \times 100$$

$$\text{Proportion (\%) of components } (X_{10}) \text{ having molecular weight of less than 10,000} = (X_{10}/A) \times 100$$

$$\text{Proportion (\%) of components } (X_{50}) \text{ having molecular weight of more than 50,000} = (X_{50}/A) \times 100$$

$$\text{Proportion (\%) of components } (X_{80}) \text{ having molecular weight of more than 80,000} = (X_{80}/A) \times 100$$

<γ Value of resist film>

For positive resist compositions produced in Examples 5 to 8, a resist film was formed on a silicon wafer and a sensitivity curve was prepared in the same way as in the evaluation method of sensitivity ($E_{th}$) of a resist film. The γ value was determined with respect to the obtained sensitivity curve (horizontal axis: common logarithm of total electron beam irradiation dose; vertical axis: remaining film fraction of resist film ($0 \leq$ remaining film fraction $\leq 1.00$)) by the following formula. In the following formula, $E_0$ is the logarithm of the total irradiation dose obtained when the sensitivity curve is fitted to a quadratic function in a range from a remaining film fraction of 0.20 to a remaining film fraction of 0.80, and then a remaining film fraction of 0 is substituted with respect to the obtained quadratic function (function of remaining film fraction and common logarithm of total irradiation dose). Also, $E_1$ is the logarithm of the total irradiation dose obtained when a straight line is prepared that joins points on the obtained quadratic function corresponding to remaining film fractions of 0 and 0.50 (linear approximation for gradient of sensitivity curve), and then a remaining film fraction of 1.00 is substituted with respect to the obtained straight line (function of remaining film fraction and common logarithm of total irradiation dose). The following formula expresses the gradient of the straight line between a remaining film fraction of 0 and a remaining film fraction of 1.00.

$$\gamma = \left|\log_{10}\left(\frac{E_1}{E_0}\right)\right|^{-1}$$

A larger γ value indicates that the sensitivity curve has a larger gradient and that a pattern having high clarity can be more favorably formed.

(Example 1)

<Production of polymer>

A monomer composition containing 3.0 g of 2,2,2-trifluoroethyl α-chloroacrylate as monomer (a), 4.40 g of α-methylstyrene as monomer (b), 1.85 g of cyclopentanone as a solvent, and 0.006975 g of azobisisobutyronitrile as a polymerization initiator was added into a glass container. The glass container was tightly sealed and purged with nitrogen, and was then stirred for 6.0 hours in a 78°C thermostatic tank under a nitrogen atmosphere. Thereafter, the glass container was returned to room temperature, the inside of the glass container was exposed to the atmosphere, and then 10 g of tetrahydrofuran (THF) was added to the resultant solution. The solution to which the THF had been added was then dripped into 300 g of methanol to precipitate a polymerized product. Thereafter, the solution containing the polymerized product that had been precipitated was filtered using a Kiriyama funnel to obtain a white coagulated material

(polymer). The obtained polymer comprised 50 mol% of α-methylstyrene units and 50 mol% of 2,2,2-trifluoroethyl α-chloroacrylate units.

The weight average molecular weight, number average molecular weight, and molecular weight distribution of the obtained polymer were measured. The results are shown in Table 1.

<Production of positive resist composition>

The obtained polymer was dissolved in anisole used as a solvent to produce a resist solution (positive resist composition) in which the concentration of the polymer was 11 mass%. The sensitivity and pattern collapse resistance of a positive resist comprising the polymer were evaluated. The results are shown in Table 1.

(Example 2)

<Production of polymer>

A monomer composition containing 3.0 g of methyl α-fluoroacrylate as monomer (a), 7.97 g of α-methylstyrene as monomer (b), and 0.01263 g of azobisisobutyronitrile as a polymerization initiator was added into a glass container. The glass container was tightly sealed and purged with nitrogen, and was then stirred for 60.0 hours in a 78°C thermostatic tank under a nitrogen atmosphere. Thereafter, the glass container was returned to room temperature, the inside of the glass container was exposed to the atmosphere, and then 10 g of tetrahydrofuran (THF) was added to the resultant solution. The solution to which the THF had been added was then dripped into 300 g of methanol to precipitate a polymerized product. Thereafter, the solution containing the polymerized product that had been precipitated was filtered using a Kiriyama funnel to obtain a white coagulated material (polymer). The obtained polymer comprised 50 mol% of α-methylstyrene units and 50 mol% of methyl α-fluoroacrylate units.

The weight average molecular weight, number average molecular weight, and molecular weight distribution of the obtained polymer were measured. The results are shown in Table 1.

<Production of positive resist composition>

The obtained polymer was dissolved in anisole used as a solvent to produce a resist solution (positive resist composition) in which the concentration of the polymer was 11 mass%. The sensitivity and pattern collapse resistance of a positive resist comprising the polymer were evaluated. The results are shown in Table 1.

(Example 3)

<Production of polymer>

A monomer composition containing 3.0 g of methyl α-chloroacrylate as monomer (a), 7.93 g of α-methyl-4-fluorostyrene as monomer (b), 2.74 g of cyclopentanone as a solvent, and 0.01091 g of azobisisobutyronitrile as a polymerization initiator was added into a glass container. The glass container was tightly sealed and purged with nitrogen, and was then stirred for 6.0 hours in a 78°C thermostatic tank under a nitrogen atmosphere. Thereafter, the glass container was returned to room temperature, the inside of the glass container was exposed to the atmosphere, and then 10 g of tetrahydrofuran (THF) was added to the resultant solution. The solution to which the THF had been added was then dripped into 300 g of methanol to precipitate a polymerized product. Thereafter, the solution containing the polymerized product that had been precipitated was filtered using a Kiriyama funnel to obtain a white coagulated material (polymer). The obtained polymer comprised 50 mol% of α-methyl-4-fluorostyrene units and 50 mol% of methyl α-chloroacrylate units.

The weight average molecular weight, number average molecular weight, and molecular weight distribution of the obtained polymer were measured. The results are shown in Table 1.

<Production of positive resist composition>

The obtained polymer was dissolved in anisole used as a solvent to produce a resist solution (positive resist composition) in which the concentration of the polymer was 11 mass%. The sensitivity and pattern collapse resistance of a positive resist comprising the polymer were evaluated. The results are shown in Table 1.

(Example 4)

<Production of polymer>

A monomer composition containing 3.0 g of 2,2,2-trifluoroethyl α-fluoroacrylate as monomer (a), 4.82 g of α-methylstyrene as monomer (b), and 0.00764 g of azobisisobutyronitrile as a polymerization initiator was added into a glass container. The glass container was tightly sealed and purged with nitrogen, and was then stirred for 60.0 hours in a 78°C thermostatic tank under a nitrogen atmosphere. Thereafter, the glass container was returned to room temperature, the inside of the glass container was exposed to the atmosphere, and then 10 g of tetrahydrofuran (THF) was added to the resultant solution. The solution to which the THF had been added was then dripped into 300 g of methanol to precipitate a polymerized product. Thereafter, the solution containing the polymerized product that had been precipitated was filtered using a Kiriyama funnel to obtain a white coagulated material (polymer). The obtained polymer comprised 50 mol% of α-methylstyrene units and 50 mol% of 2,2,2-trifluoroethyl α-fluoroacrylate units.
The weight average molecular weight, number average molecular weight, and molecular weight distribution of the obtained polymer were measured. The results are shown in Table 1.

<Production of positive resist composition>

The obtained polymer was dissolved in anisole used as a solvent to produce a resist solution (positive resist composition) in which the concentration of the polymer was 11 mass%. The sensitivity and pattern collapse resistance of a positive resist comprising the polymer were evaluated. The results are shown in Table 1.

(Comparative Example 1)

<Production of polymer>

A monomer composition containing 3.0 g of methyl α-chloroacrylate and 6.88 g of α-methylstyrene as monomers, 2.47 g of cyclopentanone as a solvent, and 0.01091 g of azobisisobutyronitrile as a polymerization initiator was added into a glass container. The glass container was tightly sealed and purged with nitrogen, and was then stirred for 6.5 hours in a 78°C thermostatic tank under a nitrogen atmosphere. Thereafter, the glass container was returned to room temperature, the inside of the glass container was exposed to the atmosphere, and then 30 g of tetrahydrofuran (THF) was added to the resultant solution. The solution to which the THF had been added was then dripped into 300 g of methanol to precipitate a polymerized product. Thereafter, the solution containing the polymerized product that had been precipitated was filtered using a Kiriyama funnel to obtain a white coagulated material (polymer). The obtained polymer comprised 50 mol% of α-methylstyrene units and 50 mol% of methyl α-chloroacrylate units.
The weight average molecular weight, number average molecular weight, and molecular weight distribution of the obtained polymer were measured. The results are shown in Table 1.

<Production of positive resist composition>

The obtained polymer was dissolved in anisole used as a solvent to produce a resist solution (positive resist composition) in which the concentration of the polymer was 11 mass%. The sensitivity and pattern collapse resistance of a positive resist comprising the polymer were evaluated. The results are shown in Table 1.

(Example 5)

<Production of polymer>

A polymerized product and a positive resist composition were obtained in the same way as in Example 1 with the exception that the amount of azobisisobutyronitrile used as a polymerization initiator was changed to 0.069751 g and the amount of cyclopentanone used as a solvent was changed to 1.87 g. The obtained polymerized product had a weight average molecular weight (Mw) of 21,807, a number average molecular weight (Mn) of 14,715, and a molecular weight distribution (Mw/Mn) of 1.48. Moreover, the obtained polymerized product comprised 50 mol% of 2,2,2-trifluoroethyl α-chloroacrylate units and 50 mol% of α-methylstyrene units. The proportions of components in the obtained polymerized product having various molecular weights were measured. Moreover, the pattern collapse resistance, sensitivity, and γ value of a positive resist film were evaluated for the obtained positive resist composition as previously described. The results are shown in Table 2. In each of the evaluations, a developer containing 62.5 vol% of a fluorine-containing solvent (produced by Du Pont-Mitsui Fluorochemicals Co., Ltd.; Vertrel® XF; $CF_3CFHCFHCF_2CF_3$) and 37.5

vol% of isopropyl alcohol was used as a developer in formation of a positive resist.

(Example 6)

Measurements and evaluations were performed in the same way as in Example 5 with the exception that a developer containing 75.0 vol% of a fluorine-containing solvent (produced by Du Pont-Mitsui Fluorochemicals Co., Ltd.; Vertrel® XF; $CF_3CFHCFHCF_2CF_3$) and 25.0 vol% of isopropyl alcohol was used as a resist developer in formation of a positive resist in each evaluation. The results are shown in Table 2.

(Example 7)

A polymerized product was obtained in the same way as in Example 1. The obtained polymerized product had a weight average molecular weight (Mw) of 50,883, a number average molecular weight (Mn) of 31,303, and a molecular weight distribution (Mw/Mn) of 1.63. Moreover, the obtained polymerized product comprised 50 mol% of 2,2,2-trifluoroethyl $\alpha$-chloroacrylate units and 50 mol% of $\alpha$-methylstyrene units.

The proportions of components in the polymerized product having various molecular weights were measured in the same way as in Example 5. The results are shown in Table 2. A positive resist composition was produced in the same way as in Example 1, and measurements and evaluations were performed in the same way as in Example 5. The results are shown in Table 2.

(Example 8)

Measurements and evaluations were performed in the same way as in Example 7 with the exception that a developer containing 75.0 vol% of a fluorine-containing solvent (produced by Du Pont-Mitsui Fluorochemicals Co., Ltd.; Vertrel® XF; $CF_3CFHCFHCF_2CF_3$) and 25.0 vol% of isopropyl alcohol was used as a resist developer in formation of a positive resist. The results are shown in Table 2.

Table 1

| | Example 1 | Example 2 | Example 3 | Example 4 | Comparative Example 1 |
|---|---|---|---|---|---|
| Weight average molecular weight [-] | $5.1 \times 10^4$ | $5.4 \times 10^4$ | $5.0 \times 10^4$ | $5.5 \times 10^4$ | $5.5 \times 10^4$ |
| Molecular weight distribution [-] | 1.63 | 2.34 | 1.70 | 2.30 | 1.85 |
| Sensitivity | A | C | B | B | B |
| Pattern collapse resistance | A | A | A | A | B |

Table 2

| | | | Example 5 | Example 6 | Example 7 | Example 8 |
|---|---|---|---|---|---|---|
| Resist composition | Polymer | Weight average molecular weight (Mw) [-] | 21807 | 21807 | 50883 | 50883 |
| | | Number average molecular weight (Mn) [-] | 14715 | 14715 | 31303 | 31303 |
| | | Molecular weight distribution (Mw/Mn) [-] | 1.48 | 1.48 | 1.63 | 1.63 |
| | | Proportion of components having molecular weight of less than 6,000 [%] | 6.51 | 6.51 | 0.23 | 0.23 |
| | | Proportion of components having molecular weight of less than 10,000 [%] | 19.44 | 19.44 | 2.49 | 2.49 |
| | | Proportion of components having molecular weight of more than 50,000 [%] | 4.38 | 4.38 | 36.41 | 36.41 |
| | | Proportion of components having molecular weight of more than 80,000 [%] | 0.78 | 0.78 | 15.04 | 15.04 |
| Developer | Formulation | Fluorine-containing solvent [vol%] | 62.5 | 75.0 | 62.5 | 75.0 |
| | | Isopropyl alcohol [vol%] | 37.5 | 25.0 | 37.5 | 25.0 |
| Evaluation | | Pattern collapse resistance | A | A | A | A |
| | | $E_{th}$ [$\mu C/cm^2$] | 108.4 | 112.4 | 124.8 | 136.8 |
| | | $\gamma$ Value [-] | 42.238 | 46.958 | 39.199 | 40.862 |

It can be seen from Tables 1 and 2 that positive resists of Examples 1 to 8, which each comprise a specific polymer formed using specific monomers including a fluorine atom, have excellent pattern collapse resistance compared to a positive resist of Comparative Example 1, which comprises a polymer that does not include fluorine atoms.

Moreover, it can be seen from Tables 1 and 2 that positive resists comprising the polymers of Examples 1, 7, and 8, and Examples 5 and 6 have high sensitivity, and these polymers have excellent main chain scission properties upon irradiation with ionizing radiation or the like.

Also, it can be seen from Table 2 that when the positive resists of Examples 5 to 8, which each comprise a specific polymer formed using specific monomers including a fluorine atom, are developed using a developer that contains an alcohol and a fluorine-containing solvent and has a fluorine-containing solvent content of 60 vol% or more, the value of $E_{th}$ decreases (i.e., resist film sensitivity increases), and a resist pattern can be efficiently and favorably formed.

Furthermore, it can be seen from Table 2 that when the positive resists of Examples 5 and 6, which each comprise a polymer including fluorine atoms and having a weight average molecular weight of less than 22,000, are developed using a developer that contains an alcohol and a fluorine-containing solvent and has a fluorine-containing solvent content of 60 vol% or more, the value of $E_{th}$ decreases significantly (i.e., resist film sensitivity increases significantly), and a resist pattern can be particularly efficiently and favorably formed.

INDUSTRIAL APPLICABILITY

Through the presently disclosed polymer, it is possible to provide a main chain scission-type positive resist that can sufficiently inhibit resist pattern collapse when the polymer is used as a resist.

Moreover, the presently disclosed positive resist composition enables favorable formation of a resist pattern.

Furthermore, the presently disclosed method of forming a resist pattern enables efficient formation of a resist pattern.

## Claims

1. A polymer comprising:

a monomer unit (A) represented by general formula (I), shown below,

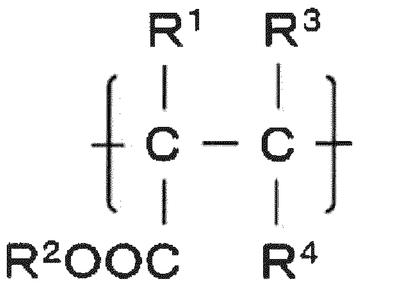

··· (I)

where, in general formula (I), $R^1$ is a chlorine atom, $R^2$ is an unsubstituted alkyl group or a fluorine atom-substituted alkyl group, and $R^3$ and $R^4$ are each a hydrogen atom, a fluorine atom, an unsubstituted alkyl group, or a fluorine atom-substituted alkyl group and may be the same or different; and

a monomer unit (B) represented by general formula (II), shown below,

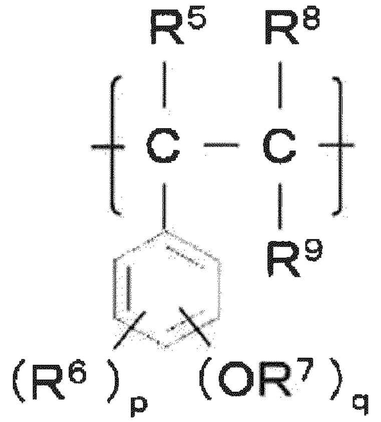

··· (II)

where, in general formula (II), $R^5$, $R^6$, $R^8$, and $R^9$ are each a hydrogen atom, a fluorine atom, an unsubstituted alkyl group, or a fluorine atom-substituted alkyl group and may be the same or different, $R^7$ is a hydrogen atom, an unsubstituted alkyl group, or a fluorine atom-substituted alkyl group, p and q are each an integer of at least 0 and not more than 5, and $p + q = 5$, wherein

at least one of the monomer unit (A) and the monomer unit (B) includes at least one fluorine atom;

the polymer has a weight average molecular weight of at least 10,000 and not more than 150,000; and

the polymer has a molecular weight distribution (Mw/Mn) of at least 1.30 and not more than 1.60.

2. The polymer according to claim 1, wherein

$R^2$ is a fluorine atom-substituted alkyl group, and

$R^3$ and $R^4$ are each a hydrogen atom or an unsubstituted alkyl group.

3. The polymer according to claim 1 or 2, wherein
$R^5$ to $R^9$ are each a hydrogen atom or an unsubstituted alkyl group, and the monomer unit (A) includes at least one fluorine atom.

4. The polymer according to any one of claims 1 to 3, having a weight average molecular weight of less than 22,000.

5. A positive resist composition comprising:

the polymer according to any one of claims 1 to 4; and

a solvent.

**6.** A method of forming a resist pattern comprising:

forming a resist film using the positive resist composition according to claim 5;
exposing the resist film; and
developing the resist film that has been exposed, wherein
the developing is carried out using a developer that contains an alcohol and a fluorine-containing solvent and has a fluorine-containing solvent content of 60 vol% or more.

## Patentansprüche

**1.** Ein Polymer, umfassend:

eine Monomereinheit (A), dargestellt durch die allgemeine Formel (I), wie nachstehend gezeigt,

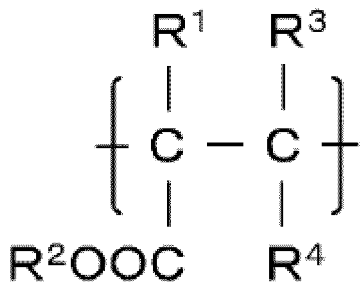

··· (I)

wobei in der allgemeinen Formel (I) $R^1$ ein Chloratom ist, $R^2$ eine unsubstituierte Alkylgruppe oder eine mit einem Fluoratom substituierte Alkylgruppe ist, und $R^3$ und $R^4$ jeweils ein Wasserstoffatom, ein Fluoratom, eine unsubstituierte Alkylgruppe oder eine mit einem Fluoratom substituierte Alkylgruppe sind und gleich oder verschieden sein können;und
eine Monomereinheit (B), dargestellt durch die allgemeine Formel (II), wie nachstehend gezeigt

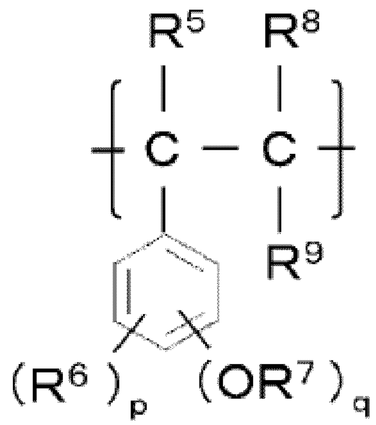

··· (II)

wobei in der allgemeinen Formel (II) $R^5$, $R^6$, $R^8$ und $R^9$ jeweils ein Wasserstoffatom, ein Fluoratom, eine unsubstituierte Alkylgruppe oder eine mit einem Fluoratom substituierte Alkylgruppe sind und gleich oder verschieden sein können, $R^7$ ein Wasserstoffatom, eine unsubstituierte Alkylgruppe oder eine mit einem Fluoratom substituierte Alkylgruppe ist, p und q jeweils eine ganze Zahl von mindestens 0 und nicht mehr als 5 sind und p + q = 5 ist, wobei
mindestens eine von Monomereinheit (A) und Monomereinheit (B) mindestens ein Fluoratom enthält;
das Polymer ein Gewichtsmittel des Molekulargewichts von mindestens 10.000 und nicht mehr als 150.000 aufweist; und
das Polymer eine Molekulargewichtsverteilung (Mw/Mn) von mindestens 1,30 und nicht mehr als 1,60 aufweist.

**2.** Das Polymer nach Anspruch 1, wobei

$R^2$ eine mit einem Fluoratom substituierte Alkylgruppe ist und
$R^3$ und $R^4$jeweils ein Wasserstoffatom oder eine unsubstituierte Alkylgruppe sind.

**3.** Das Polymer nach Anspruch 1 oder 2, wobei
$R^5$ bis $R^9$ jeweils ein Wasserstoffatom oder eine unsubstituierte Alkylgruppe sind, und die Monomereinheit (A) mindestens ein Fluoratom enthält.

**4.** Das Polymer nach einem der Ansprüche 1 bis 3 mit einem Gewichtsmittel des Molekulargewichts von weniger als 22.000.

**5.** Eine positiv arbeitende Resistzusammensetzung, umfassend

das Polymer nach einem der Ansprüche 1 bis 4; und
ein Lösungsmittel.

**6.** Ein Verfahren zur Herstellung eines Resistmusters, umfassend:

Bilden eines Resistfilms unter Verwendung der positiv arbeitenden Resistzusammensetzung nach Anspruch 5;
Belichten des Resistfilms; und
Entwickeln des Resistfilms, der belichtet wurde, wobei
das Entwickeln unter Verwendung eines Entwicklers durchgeführt wird, der einen Alkohol und ein fluorhaltiges Lösungsmittel enthält und einen Gehalt an fluorhaltigem Lösungsmittel von 60 Vol.-% oder mehr aufweist.

## Revendications

**1.** Polymère comprenant :

un motif monomère (A) représenté par la formule générale (I), illustrée ci-dessous,

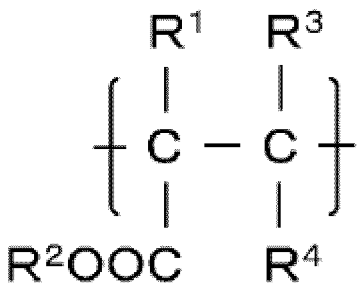

··· (I)

où, dans la formule générale (I), $R^1$ est un atome de chlore, $R^2$ est un groupe alkyle non substitué ou un groupe alkyle substitué par un atome de fluor, et $R^3$ et $R^4$ sont chacun un atome d'hydrogène, un atome de fluor, un groupe alkyle non substitué ou un groupe alkyle substitué par un atome de fluor et peuvent être identiques ou différents ; et
un motif monomère (B) représenté par la formule générale (II), illustrée ci-dessous,

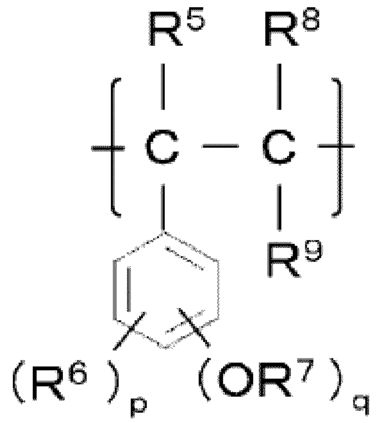 ··· (II)

où, dans la formule générale (II), $R^5$, $R^6$, $R^8$ et $R^9$ sont chacun un atome d'hydrogène, un atome de fluor, un groupe alkyle non substitué ou un groupe alkyle substitué par un atome de fluor et peuvent être identiques ou différents, $R^7$ est un atome d'hydrogène, un groupe alkyle non substitué ou un groupe alkyle substitué par un atome de fluor, p et q sont chacun un nombre entier d'au moins 0 et de pas plus de 5, et p + q = 5, dans lequel au moins l'un parmi le motif monomère (A) et le motif monomère (B) comprend au moins un atome de fluor ;
le polymère a un poids moléculaire moyen en poids d'au moins 10 000 et de pas plus de 150 000 ; et
le polymère a une distribution de poids moléculaire (Mm/Mn) d'au moins 1,30 et de pas plus de 1,60.

**2.** Polymère selon la revendication 1, dans lequel

$R^2$ est un groupe alkyle substitué par un atome de fluor, et
$R^3$ et $R^4$ sont chacun un atome d'hydrogène ou un groupe alkyle non substitué.

**3.** Polymère selon la revendication 1 ou 2, dans lequel

$R^5$ à $R^9$ sont chacun un atome d'hydrogène ou un groupe alkyle non substitué, et
le motif monomère (A) comprend au moins un atome de fluor.

**4.** Polymère selon l'une quelconque des revendications 1 à 3, ayant un poids moléculaire moyen en poids inférieur à 22 000.

**5.** Composition de réserve positive comprenant :

le polymère selon l'une quelconque des revendications 1 à 4 ; et
un solvant.

**6.** Procédé de formation d'un motif de réserve comprenant :

la formation d'un film de réserve à l'aide de la composition de réserve positive selon la revendication 5 ;
l'exposition du film de réserve ; et
le développement du film de réserve qui a été exposé, dans lequel
le développement est effectué à l'aide d'un agent de développement qui contient un alcool et un solvant contenant du fluor et a une teneur en solvant contenant du fluor de 60 % en volume ou plus.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H83636 B
- JP S57118243 A
- JP S5949536 A
- JP S61170735 A
- JP H02115852 A
- US 2010203450 A1